# FASCICULE DE BREVET EUROPEEN

(11) **EP 0 334 432 B1**
(45) Date de publication et mention de la délivrance du brevet: **13.10.1993**
(21) Numéro de dépôt: 89200664.4
(22) Date de dépôt: 16.03.1989
(51) Int. Cl.: C30B 25/08, C30B 25/10, C23C 16/44

(54) **Réacteur d'épitaxie à paroi protégée contre les dépôts**
Epitaxiereaktor mit einer gegen Beschlag geschützten Wand
Epitaxy reactor with wall protected against deposits

(30) Priorité: 22.03.1988 FR 8803689
(43) Date de publication de la demande: 27.09.1989
(73) Titulaire: LABORATOIRES D'ELECTRONIQUE PHILIPS, 94450 Limeil-Brévannes (FR); Philips Electronics N.V., 5621 BA Eindhoven (NL)
(72) Inventeur: Frijlink, F-75007 Paris (FR)
(74) Mandataire: Caron, Jean

(56) Documents cités:
- FR-A- 2 114 105
- FR-A- 2 596 070
- PATENT ABSTRACTS OF JAPAN, vol. 10, no. 133 (E-404)[2190], 17 mai 1986#

## Description

L'invention concerne un réacteur d'épitaxie comprenant une enceinte à l'intérieur de laquelle au moins une plaquette de matériau semi-conducteur est exposée à un courant gazeux réactif, et des moyens pour chauffer cette plaquette qui ainsi dégage de la chaleur, l'enceinte comportant une paroi horizontale refroidie extérieurement au moyen d'une circulation de fluide, et qui possède une surface interne disposée à faible distance au dessus de la plaquette exposée au gaz réactif.

Un tel réacteur est connu du document FR-A-2 114 105.

Les parois des réacteurs d'épitaxie ont tendance à être salies par des dépôts provoqués par une réaction entre les produits réactifs employés .

Dans le cas où les plaquettes sont disposées horizontalement, le problème des dépôts est particulièrement aigu, car ces dépôts ont tendance à s'écailler sous l'influence des différences de coefficients de dilatation et à laiser tomber des débris sur les plaquettes, chacun de ces débris entraînant la défectuosité d'un des multiples circuits en cours de réalisation (chaque plaquette est subdivisée en un grand nombre de circuits).

Une telle salissure, qui est particulièrement gênante à proximité des faces utiles des plaquettes, peut être évitée si les parois sont portées à une température bien déterminée.

Un moyen pour y arriver est de prévoir une régulation de la température des parois. C'est ce qui est enseigné par le document JP-A-60 262 418. Le réacteur selon ce document comprend un conduit spiralé appliqué sur la paroi du réacteur et dans lequel circule un fluide. La température de la paroi est régulée du fait que la température est mesurée et agit par rétroaction sur une valve qui commande le débit de fluide. Néanmoins un tel moyen est complexe et coûteux.

L'invention fournit un moyen simple et économique d'obtenir une paroi à la température désirée.

L'invention est basée sur l'idée qu'il suffit de régler la fuite thermique au travers de la paroi vers l'extérieur pour obtenir toute température de paroi désirée, inférieure à la température des plaquettes.

Pour mettre en oeuvre ce moyen, le réacteur selon l'invention est remarquable en ce que la conductibilité thermique de cette paroi est réglable du fait qu'elle est munie, à faible distance de sa surface interne qui est située vis à vis de la plaquette, d'un espace creux distinct de l'espace réservé à la dite circulation de fluide et de l'espace réservé au dit courant gazeux réactif et de moyens pour, en cours de fonctionnement, introduire dans le dit espace creux un mélange de fluides en proportion réglable à volonté, fluides distincts de ceux du courant réactif ou du fluide de refroidissement, cet espace étant suffisamment mince pour que le transfert de chaleur vers l'extérieur à travers lui s'effectue essentiellement par conduction et non par convection et dépende ainsi du coefficient de conduction thermique du fluide dont il est rempli.

Afin que le moyen soit le plus efficace possible, l'épaisseur dudit espace est de préférence comprise entre 0,1 et 1mm.

Le mélange utilisé est avantageusement un mélange de gaz, le mélange préféré étant un mélange d'hydrogène et d'argon, la proportion de chacun dans le mélange étant ajustable.

Dans une forme de réalisation avantageuse, la paroi est constituée d'une plaque interne de quartz, qui est bien appropriée pour être en contact avec les gaz réactifs, et d'une paroi extérieure en métal. Le susdit espace est constitué par un intervalle ménagé entre la plaque de quartz et la paroi métallique. La paroi extérieure est bonne conductrice de la chaleur, et ainsi la résistance thermique de l'ensemble dépend surtout des caractéristiques du mélange introduit dans l'espace mince.

Afin d'obtenir un profil thermique qui fournit des dépôts d'épaisseur constante, l'espace est divisé en plusieurs parties alimentées en gaz indépendamment les unes des autres.

La description qui va suivre, en regard des dessins annexés décrivant des exemples non limitatifs fera bien comprendre comment l'invention peut être réalisée.

La figure 1 est une demi-vue latérale en coupe (selon la ligne AA de la figure 2) d'un réacteur selon l'invention, qui traite cinq plaquettes à la fois.

La figure 2 est une vue de dessus du même réacteur, avec le couvercle enlevé, à une échelle réduite d'environ moitié par rapport à celle de la figure 1.

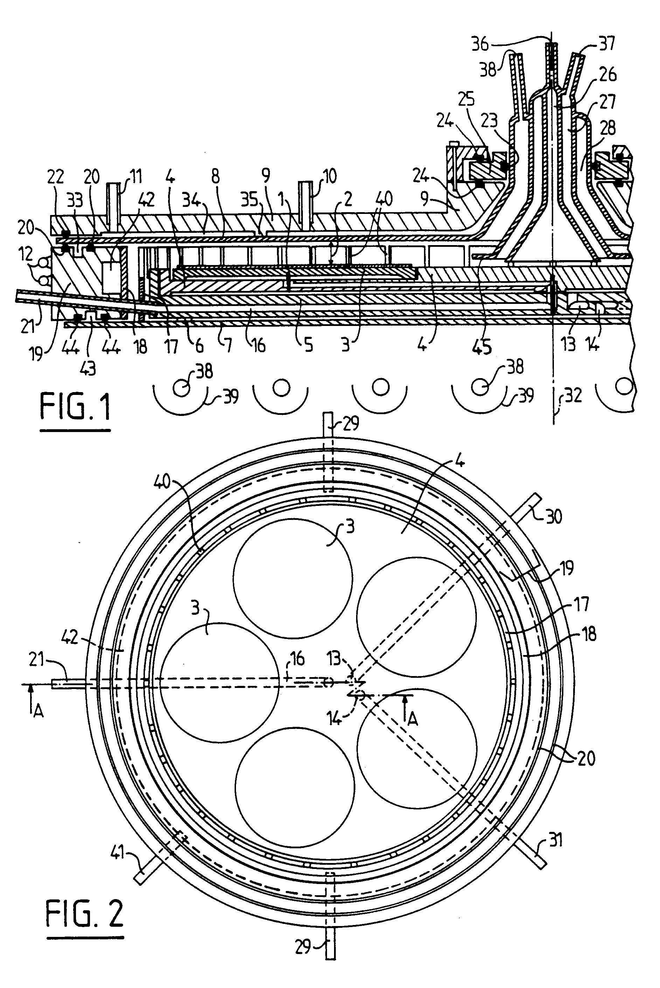

Afin de pouvoir réaliser un dessin à plus grande échelle, la figure 1 ne représente qu'un peu plus de la moitié d'un réacteur. Avec l'aide de la figure 2, la partie non représentée se déduit aisément à partir des éléments représentés.

Le support des plaquettes est constitué d'un disque fixe 5 en graphite percé de trous pour amener un gaz qui permet de soulever légèrement et de mettre en rotation les disques supports de plaquettes. Le disque 5 porte un disque principal rotatif 4 d'environ 25 cm de diamètre et ce disque porte à son tour plusieurs disques rotatifs secondaires 3 sur chacun desquels est posée une plaquette ou tranche de semiconducteur 1. Un tube 21 d'amenée de gaz de sustentation pénètre dans le disque fixe 5. Ce dispositif est décrit plus en détail dans le document FR-A-2 596070 qui peut être consulté à titre d'exemple de réalisation.

L'enceinte du réacteur est constituée d'un corps cylindrique 19 d'axe vertical 32 de section circulaire sur lequel sont appliqués hermétiquement un couvercle 8 et un fond 7.

Ce corps est refroidi par un serpentin constitué de tubes 12 qui lui sont soudés et dans lequel circule de l'eau. Le corps est réalisé en acier inoxydable.

Le fond du réacteur est constitué par une simple plaque de quartz circulaire 7 dont l'épaisseur est d'environ 4 mm. L'étanchéité est assurée par 2 joints toriques 44 entre lesquels est creusée une gorge 43 dans laquelle on fait le vide.

Sous le fond 7 sont disposées des lampes infrarouges tubulaires 38 munies de réflecteurs 39, fournissant un rayonnement infrarouge qui traverse le fond 7 et chauffe le support de graphite 5. L'utilisation d'une pluralité de lampes permet de moduler leur puissance relative pour obtenir une régularité parfaite du chauffage depuis le centre jusqu'à l'extérieur du disque.

Le couvercle est constitué d'un disque de quartz 8 (figure 1) dont l'épaisseur est d'environ 4mm, appliqué sur des joints toriques 20 entre lesquels est prévue une gorge 33 comme la gorge 43 à la partie inférieure. La partie centrale du couvercle est relevée en forme d'entonnoir 28. Du gaz réactif peut être amené dans cet entonnoir par le tube 38. A l'intérieur de l'entonnoir 28 sont prévus deux autres volumes 26 et 27 concentriques dont la partie inférieure est en forme d'entonnoir avec la partie évasée vers le bas. Chacun des volumes 26 et 27 communique avec une source de gaz réactif par un tube respectivement 36, 37. Le tube intérieur 36 permet d'amener par exemple de l'arsine ou du phosphine prédilué dans l'hydrogène ; le second conduit 37 amène par exemple de l'hydrogène, et le conduit extérieur 38 peut amener un mélange de corps organo-métalliques dilués dans de l'hydrogène. Les gaz réactifs passent dans l'espace 2 entre les plaquettes 1 et le couvercle 8, puis par des fentes 40 ménagées dans une couronne de quartz 17 qui entoure le support 5, puis par un espace annulaire entre la couronne 17 et une autre couronne de quartz 18, et sortent enfin par des tubes (29 sur la figure 2).

Ces gaz réactifs provoquent un dépôt sur les plaquettes, ce qui est souhaité, mais aussi sur la paroi interne du couvercle 8. A la longue ces dépôts s'accumulent puis s'écaillent et des particules tombent sur les plaquettes en cours de traitement, entraînant un grand nombre de défauts à leur surface.

En ce qui concerne la partie métallique 19 du corps et le dessous en graphite du support des plaquettes, les dépôts, qui d'ailleurs y sont moins gênants que sur le couvercle, peuvent être évités en empêchant le contact avec les gaz réactifs. A cet effet le corps 19 est doublé par une paroi de quartz 18, et de l'hydrogène est amené dans une gorge cylindrique 42 et entre dans l'enceinte en passant par l'interstice entre le corps 19 et la paroi 18, créant un contre-flux d'hydrogène. De même un tube débouchant en 14 vers le dessous du support 5 y pousse un contre flux d'hydrogène qui balaie le dessous du support.

Sur la figure 2, qui représente le réacteur couvercle enlevé on peut voir la disposition des différents tubes traversant le corps 19 : le tube 21 d'amenée des gaz de sustentation qui débouche dans le bloc de graphite 5,le tube 31 débouchant en 14 pour débiter du gaz sous l'ensemble support de plaquettes, le tube 30 qui débouche en 13 pour fournir le gaz de sustentation du disque principal 4, le tube 16 creusé dans la partie fixe du support de plaquettes et qui amène le gaz destiné aux disques secondaires, le tube 41 amenant du gaz dans la gorge annulaire 42, et les tubes 29 d'évacuation des gaz réactifs. Le disque principal représenté ici porte cinq disques secondaires 3 de 7,62cm de diamètre.

En ce qui concerne le couvercle 8, qui délimite l'espace où se produit l'épitaxie, il n'est pas question, bien évidemment, d'en éliminer les gaz réactifs ! Il est néanmoins possible d'y éviter les dépôts, car on a remarqué que ces derniers se produisent à certaines températures et pas à d'autres. Pour des températures basses de la surface intérieure du couvercle, il y a par exemple, avec les gaz indiqués plus haut, des dépôts d'arsenic ou de phosphore. Si par contre la température est élevée il y a des dépôts d'arséniure de gallium, ou d'autres composés III-V. On a constaté par contre que, pour une température intermédiaire, de l'ordre de 450°, de la surface intérieure, il ne se produit plus que très peu de dépôt, ceci dans le cas des composés III-V.

L'ensemble support des plaquettes 5, 4, 3 et les plaquettes 1 elles-mêmes sont chauffés (par les lampes 38) et par conséquent rayonnent de la chaleur ; ce rayonnement est suffisant pour porter le couvercle 8, qui est très proche, à haute température, et c'est pourquoi des moyens sont prévus dans l'art antérieur pour en réguler la température. L'invention, au contraire, se propose de contrôler la temperature en ajustant la conduction au travers de la paroi à une valeur optimale.

Le couvercle 8 (figure 1) est maintenu sous un pièce métallique 9 qui l'appuie contre le corps 19. Entre la pièce métallique 9 et le disque 8 est ménagé un espace 34 que l'on peut, pour régler la température du couvercle, remplir d'un fluide adapté, au moyen de tuyaux 10, 11 et dont l'étanchéité est réalisée par des joints toriques 22, 23, 24. Une pièce annulaire 25 pouvant coulisser légèrement par rapport à la pièce 9 est prévue pour éviter de briser le couvercle en quartz lors du montage. La pièce métallique 9 est refroidie à l'extérieur par des moyens non représentés, qui peuvent être par exemple des tubes d'eau analogues aux tubes 12, ou bien des passages creux ménagés dans la pièce 9 et dans lesquels est prévue une circulation d'eau.

La paroi 8, 9 dont la surface interne est située à faible distance des plaquettes, et vis à vis d'elles, est donc constitué d'une plaque interne 8 en quartz, chauffée par le rayonnement des pièces 1, 3, 4, et d'une paroi externe 9 bonne conductrice de la chaleur, et refroidie par circulation d'eau. L'espace 34 qui sépare ces deux parois a une épaisseur d'environ 0,3 à 0,5 mm : il est très mince et de ce fait le transfert de chaleur vers l'extérieur au travers de cet espace s'effectue essentiellement par conduction et non par convection et dépend du coefficient de conduction thermique du fluide dont il est rempli.

Le fluide utilisé est ici un mélange de gaz. Comme l'argon est environ dix fois moins conducteur que l'hydrogène, un mélange de ces deux gaz peut avoir une conduction thermique variant dans un rapport dix selon la proportion utilisée pour le mélange. Il suffit donc de faire varier la proportion relative d'argon et d'hydrogène amenés ensemble par les tubes de remplissage 10, 11 pour obtenir une conduction thermique réglable qui permet d'ajuster aux alentours de 450° la température de la surface intérieure du couvercle.

Il faut remarquer que le fluide en question n'est pas un fluide de refroidissement (qui emporte des calories grâce à sa capacité calorifique associée à un débit de fluide) mais constitue seulement une paroi à conductibilité variable. Il est donc inutile de prévoir un débit de ce fluide, sauf pour le remplacer quand on veut faire varier sa composition. A cet effet une sortie de fluide doit être prévue de préférence dans une situation diamétralement opposée à celle des tubes 10, 11, c'est-à-dire dans le cas de la figure 1, dans la partie de droite non représentée.

Afin d'améliorer l'homogénéité de l'épaisseur des dépôts, l'espace 34 est divisé en plusieurs parties. Dans le présent exemple, la paroi métallique 9 porte une nervure circulaire 35 qui vient toucher le dessus de la paroi de quartz 8 et sépare l'espace 34 en deux parties concentriques, chacune alimentée par un tube distinct 10 ou 11. On peut donc fournir un mélange ayant une conductibilité thermique différente dans chacune de ces parties. Ceci permet de moduler le profil de température le long d'un diamètre de la paroi de quartz 8.

En outre, si des gaz qui ont été chauffés à haute température par un contact préalable avec le support 4 remontent ensuite vers le couvercle, ils risquent d'y former un dépôt. Pour éviter cela, le bord inférieur de la paroi qui sépare les entonnoirs d'introduction de gaz 27 et 28 est aplati en forme de couronne 45, de façon à empêcher le flux issu de l'entonnoir 28 d'être amené directement sur le support 4. Cette couronne 45 pourrait aussi être réalisée en métal (molybdène) et rapportée sur le cône en quartz.

## Revendications

1. Réacteur d'épitaxie comprenant une enceinte (7,8,19) à l'intérieur de laquelle au moins une plaquette de matériau semi-conducteur (1) est exposée à un courant gazeux réactif, et des moyens (38,39) pour chauffer cette plaquette qui ainsi dégage de la chaleur, l'enceinte comportant une paroi horizontale (8,9) refroidie extérieurement au moyen d'une circulation de fluide, et qui possède une surface interne disposée à faible distance au dessus de la plaquette exposée au gaz réactif, caractérisé en ce que la conductibilité thermique de cette paroi est réglable du fait qu'elle est munie, à faible distance de sa surface interne qui est située vis à vis de la plaquette, d'un espace creux (34) distinct de l'espace réservé à la dite circulation de fluide et de l'espace réservé au dit courant gazeux réactif (2) et de moyens (10,11) pour, en cours de fonctionnement, introduire dans le dit espace creux un mélange de fluides en proportion réglable à volonté, fluides distincts de ceux du courant réactif ou du fluide de refroidissement, cet espace étant suffisamment mince pour que le transfert de chaleur vers l'extérieur à travers lui s'effectue essentiellement par conduction et non par convection et dépende ainsi du coefficient de conduction thermique du fluide dont il est rempli.

2. Réacteur selon la revendication 1, caractérisé en ce que l'épaisseur dudit espace (34) est compris entre 0,1 et 1mm.

3. Réacteur selon l'une des revendications 1 ou 2, caractérisé en ce qu'il comprend des moyens pour introduire un mélange de gaz dans ledit espace (34).

4. Réacteur selon la revendication 3, caractérisé en ce qu'il comprend des moyens pour introduire un mélange d'hydrogène et d'argon dans ledit espace (34).

5. Réacteur selon l'une quelconque des revendications précédentes, caractérisé en ce que la paroi est constituée d'une plaque interne (8) de quartz et d'une paroi extérieure (9) métallique, entre lesquelles est ménagé le susdit espace (34).

6. Réacteur selon l'une quelconque des revendications précédentes, caractérisé en ce que ledit espace est divisé en plusieurs parties alimentées en mélange indépendamment les unes des autres.

7. Réacteur selon la revendication 7, caractérisé en ce que ledit espace est circulaire et est divisé en parties circulaires concentriques.

## Claims

1. An epitaxial growth reactor comprising a chamber (7,8,19) in which at least one wafer (1) of semiconductor material is exposed to a flow of reactive gas, and means (38,39) for heating said wafer, which accordingly gives off heat, the chamber comprising a horizontal wall (8,9) which is externally cooled by means of a circulation of a fluid and has an inner surface arranged at a small distance above the wafer exposed to the reactive gas, characterized in that the thermal conductivity of this wall is controllable because of the fact that at a small distance from its inner surface located opposite the wafer this wall is provided with a hollow space (34) separate from the space reserved for the said circulation of fluid and from the space reserved for the said flow of reactive gas (2), and with means (10,11) for introducing into the said hollow space a mixture of fluids in a mixing ratio which can be controlled at will during operation, which fluids are separate from those of the reactive flow or the cooling liquid, the said hollow space being sufficiently narrow to allow the heat drawn off through it to the exterior to be transported substantially by conduction and not by convection, whereby the heat transfer depends on the thermal conduction coefficient of the fluid with which the hollow space is filled.

2. A reactor as claimed in Claim 1, characterized in that the width of the said space (34) lies between 0.1 and 1 mm.

3. A reactor as claimed in one of the Claims 1 or 2, characterized in that it comprises means for introducing a gas mixture into the said space (34).

4. A reactor as claimed in Claim 3, characterized in that it comprises means for introducing a mixture of hydrogen and argon into the said space (34).

5. A reactor as claimed in any one of the preceding Claims, characterized in that the wall is formed by a quartz inner plate (8) and a metal outer wall (9), between which the said space (34) is created.

6. A reactor as claimed in any one of the preceding Claims, characterized in that the said space is divided into several portions, to each of which the mixture is fed independently.

7. A reactor as claimed in Claim 6, characterized in that the said space is circular and is divided into concentric circular portions.

## Patentansprüche

1. Epitaxiereaktor mit einem Ofen (7, 8, 19), in dessen Innere wenigstens eine Halbleitermaterialscheibe (1) einer reaktiven Gasströmung ausgesetzt wird, und mit Mitteln (38, 39) zum Erwärmen dieser Scheibe, die so die Wärme abnimmt, wobei der Ofen eine horizontale Wand (8, 9) enthält, die mittels einer Fluidströmung an der Außenseite abgekühlt wird, und eine in kurzem Abstand über der dem reaktiven Gas ausgesetzten Scheibe befindlichen inneren Fläche besitzt, dadurch gekennzeichnet, daß die Wärmeleitfähigkeit dieser Wand regelbar ist, indem sie im geringen Abstand von seiner Innenfläche, die sich gegenüber der Scheibe befindet, mit einem Hohlraum (34), der sich von dem Raum für den Fluidumlauf und von dem Raum (2) für die Reaktivgasströmung unterscheidet, und mit Mitteln (10, 11) versehen ist, um im Betrieb in diesen Hohlraum eine Fluidmischung mit beliebig regelbarem Verhältnis einzuführen, wobei die Fluide sich von denen der Reaktivströmung oder des Kühlmittels unterscheiden, und dieser Raum klein genug ist, um die Wärmeübertragung über ihn nach außen über ihn sich im wesentlichen durch Leitung und nicht durch Konvexion erfolgt und so vom Wärmeleitungskoeffizienten des Fluids abhängig ist, mit der er gefüllt ist.

2. Reaktor nach Anspruch 1, dadurch gekennzeichnet, daß die Dicke des Raumes (34) zwischen 0,1 und 1 mm liegt.

3. Reaktor nach einem der Ansprüche 1 oder 2, dadurch gekennzeichnet, daß er Mittel zum Einführen einer Gasmischung in diesen Raum (34) enthält.

4. Reaktor nach Anspruch 3, dadurch gekennzeichnet, daß er Mittel zum Einführen einer Wasserstoff- und Argonmischung in diesen Raum (34) enthält.

5. Reaktor nach einem oder mehreren der vorangehenden Ansprüche, dadurch gekennzeichnet, daß die Wand aus einer inneren Quarzwand (8) und einer externen Metallwand (9) besteht, zwischen denen der Raum (34) angeordnet ist.

6. Reaktor nach einem oder mehreren der vorangehenden Ansprüche, dadurch gekennzeichnet, daß der Raum in mehrere Abteile verteilt ist, die unabhängig voneinander mit einer Mischung gespeist werden.

7. Reaktor nach Anspruch 6, dadurch gekennzeichnet, daß der Raum kreisförmig und in konzentrische kreisförmige Abteile verteilt ist.
